# EUROPEAN PATENT SPECIFICATION

(11) **EP 0 920 654 B1**
(45) Date of publication and mention of the grant of the patent: **08.11.2000**
(21) Application number: 97939448.3
(22) Date of filing: 19.08.1997
(51) Int. Cl.: G03F 3/10, B41C 1/10

(54) **PRODUCTION OF COLOR PROOFS AND PRINTING PLATES**
VERFAHREN ZUR HERSTELLUNG VON FARBPRÜFBILDERN UND DRUCKPLATTEN
PRODUCTION D'EPREUVES EN COULEUR ET DE PLANCHES DE TIRAGE

(30) Priority: 20.08.1996 GB 9617415
(43) Date of publication of application: 09.06.1999
(73) Proprietor: MINNESOTA MINING AND MANUFACTURING COMPANY, St. Paul, Minnesota 55133-3427 (US)
(72) Inventor: PATEL, Ranjan, C., Saint Paul, MN 55133-3427 (US); SOUTER, John, Saint Paul, MN 55133-3427 (US)
(74) Representative: VOSSIUS & PARTNER
(86) International application number: US9714563
(87) International publication number: WO9808142

(56) References cited:
- WO-A-92/06410
- WO-A-94/25282

## Description

### FIELD OF THE INVENTION

This invention relates to the production of color proofs and printing plates and in particular to their production using laser thermal colorant transfer in which identical transfer donor media are used for the production of printing plate and color proof.

### BACKGROUND

In the graphic arts industry, the use of laser scanners in the reproduction of color images is known. By means of the scanner, it is possible to separate an original color image (such as a photograph or a painting) into its yellow (y), magenta (m), cyan (c) and (optionally) black (k) components (i.e., its color separation images), and to store these as separate computer data files. By recombining these color separation images in a suitable output medium, a reproduction of the original image is obtained. To an increasing extent, original color images are generated on computers in the first place, but these also take the form of digital data files representing color separation images which ultimately must be combined in a suitable output medium.

If large numbers of copies of the image are required, it is necessary to generate a separate printing plate corresponding to each of the separation images and use them to print, in exact superposition, the separate y, m, c, k separation images using inks of the appropriate colors. The process can be performed repetitively at high speed to produce many thousands of copies. Before starting such an expensive process, however, it is customary to output the separation images in the form of a color proof which is a one-off color hardcopy that predicts, as accurately as possible, the appearance of the final printed image.

There are two distinct methods by which digitally-stored color separation images may be output as plates or proofs, namely "direct" and "indirect" methods. The indirect method is the well-established technique whereby each of the stored color separation image files is output by laser scanning on to a separate black and white silver halide film which is developed and fixed in the normal manner. Each of the resulting black and white images is then used as a mask for the contact exposure of a plate or a single-color component of a photomechanical proof. Because both the plate and the proof are exposed through the same mask, and typically involve similar imaging chemistry (e.g. a photoresist), the proof provides an accurate simulation of the image that will ultimately be printed by the plate. The disadvantage of this method lies in the cost and inconvenience of using the intermediate films.

It has been recognized that "direct" laser exposure of plates and proofing materials represents a more cost-effective use of the technology and there are various disclosures of printing plates imageable by lasers. These embrace modifications to conventional plate coatings to enable laser address, as in the various photopolymer plates sensitised to Argon ion lasers and the adaptation of phenolic resin based plate coatings to infrared laser address, as disclosed in US Patent Nos. 5,340,699; 5,372,907; and 5,372,915, as well as "unconventional" imaging methods, such as laser thermal transfer.

In the laser thermal transfer method, a donor sheet comprising a layer of an infrared absorbing transfer medium is placed in contact with a receptor, and the assembly is exposed to a pattern of infrared (IR) radiation, normally from a scanning laser source. Absorption of the IR radiation causes a rapid build-up of heat in the exposed areas which in turn causes transfer of the medium from the donor to the receptor in those areas. Laser thermal transfer technology may be adapted for the production of lithographic printing plates by using a receptor having a hydrophilic surface (such as anodised aluminium foil) and transferring thereto a resinous, oleophilic material. Such systems are disclosed, for example, in US Patent Nos. 5,401,606; 5,395,729; and 5,171,650; European Patent Application Nos. 0160396; and 0160395; and Japanese Publication No. 04-140191. With a view to increasing the run-length of the resulting plates, the resinous oleophilic material is frequently designed to be crosslinkable, e.g. by heat treatment, and/or UV-irradiation, so as to enable the transferred image to he hardened in a separate post-transfer step. Such systems are disclosed, for example, in US Patent No. 5,395,729; EP Application Nos. 0160396; and 0160395. The crosslinking mechanisms disclosed include photocuring of unsaturated monomers and standard thermosetting processes such as, the thermal curing of epoxy resins, phenolformaldehyde resins, and melamine-formaldehyde resins.

Laser thermal transfer technology is also readily adaptable to the generation of color proofs. For this purpose, the transfer medium must comprise one or more dyes or pigments matching the color of one of the inks to be used in the printing process. The receptor is typically white paper or card, optionally bearing a colorless resin coating. All the separation images may be output in this fashion to a common receptor to provide a full color proof. Such systems are disclosed, for example, in US Patent Nos. 5,171,650; and 5,126,760; WO Application No. 90/12342, Japanese Publications Nos. 63-319192; and 04-201485; and European Application Nos. 0542544; and 0602893.

Laser thermal transfer is potentially a highly attractive means for generating both proofs and plates directly from digitally-stored image data, since the use of photosensitive materials and wet processing is not required. However, matched proofing and platemaking media, imageable by the same or similar laser sources to provide well-matched proofs and plates, have not so far been described in the patent literature or made available commercially. Although certain patents, such as, US Patent Nos. 5,395,729; and 5,171,650; and WO Application No. 90/12342 disclose the generation of both proofs and plates by laser thermal transfer, there is no suggestion that identical donor media might be used for both purposes, or that any advantage would be gained from doing so. Indeed the examples in these patents invariably disclose the use of different donor media formulations for the respective imaging applications.

The state of the art teaches that different (and mutually exclusive) properties are required in transfer media intended for the separate imaging applications. For printing plates, the emphasis is typically on the durability of the transferred image and its ability to print many thousands of impressions without suffering undue wear. Hence, there is a tendency to use thicker transfer layers comprising tough, abrasion resistant resins, frequently hardenable by a post-transfer heat or UV treatment, but rarely containing dyes or pigments other than that required for absorption of the laser radiation (which is frequently a black-body absorber, such as, carbon black). In contrast, the important criteria for proofing media have been seen as the sensitivity of the imaging process, and the resolution and color fidelity of the transferred image, leading to the use of thin layers with a high pigment content, and the use of infrared-absorbing species that impart no visible coloration to the transferred image.

While these disparate approaches have been successful in optimising the performance of proofing and plate-forming media, judging each with respect to its own particular criteria, they make the correspondence between the proof and the plates (and ultimately the printed image) less accurate. Ideally, a given set of image signals, controlling a given laser imaging device, should produce the same results in both the proof and the plate, particularly with respect to parameters, such as, dot size, and dot shape. Furthermore, any alteration to those signals (in pursuit, say, of a different color balance) should produce identical changes in both proof and plate. When transfer media with widely differing physico-chemical properties are used for the respective imaging applications, these goals become increasingly difficult to meet.

### SUMMARY OF THE INVENTION

The present invention provides a method of image reproduction comprising the steps of:
(a) generating separate digital data sets representative of color separation images for a multicolor image;
(b) providing a first laser thermal transfer donor element comprising a support having coated thereon one or more layers comprising an infrared absorber and a dispersion of a colorant in an oleophilic resin, the colorant matching the color of one of the color separation images;
(c) assembling the first donor element in contact with a first receptor;
(d) scanning the first donor element with a laser having an output modulated in accordance with the digital data set representative of the separation image whose color matches the colorant used in step (b);
(e) transferring the one or more layers of the first donor element in areas struck by the laser to form an image on the first receptor;
(f) providing a second laser thermal transfer donor element identical to the first laser thermal transfer donor;
(g) assembling the second donor element in contact with a second receptor having a hydrophilic surface suitable for use in lithographic printing:
(h) scanning the second donor element with the laser modulated in accordance with the same digital data set as used in step (d);
(i) transferring the one or more layers in areas struck by the laser to form an image on the second receptor; and
(j) repeating steps (b) through (i) at least once, wherein a different colorant is used on each repetition of step (b), the first receptor is used on each repetition of step (c), and a different hydrophilic receptor is used on each repetition of step (g).

The order in which the various steps are carried out may be varied. In particular, it is preferable to carry out all the repetitions of steps (h) through (c) before any of the iterations of steps (f) through (i) are carried out.

The invention enables the generation of well-matched proofs and plates by direct digital address since identical transfer media are used in the respective imaging processes. A further advantage afforded by the invention is the fact that each plate bears a resin image of a color that matches the color of the ink that will be used with that plate. In other words, the identity of each plate (i.e. whether it bears the y, m, c or k separation image) is immediately apparent by visual inspection, thus removing any risk of confusion and any need to provide individual plates with identification marks.

### DETAILED DESCRIPTION

Laser thermal transfer donor elements suitable for use in the present invention comprise a support bearing a coating (in one or more layers) of a transfer medium comprising an oleophilic resin, a colorant and an infrared absorber, and these ingredients must be selected to be compatible with both printing and proofing applications. The oleophilic resin may be regarded as the primary imaging component for the purposes of printing plate formation, and must provide a durable, ink-accepting image when transferred to a hydrophilic surface such as anodised aluminium. For the purposes of color proofing, the oleophilic resin acts as a binder for the dyes and/or pigments providing the necessary color, and hence should have good dispersing and film-forming properties and should have physico-chemical properties consistent with the formation of tack-free coatings, resistant to damage in the form of flaking, peeling or abrasion in the course of normal handling and storage. Solubility in common organic coating solvents, such as lower alcohols, ketones, ethers, hydrocarbons is also highly desirable.

Within these constraints, a wide variety of polymers may be suitable (including blends of two or more different polymers, or mixtures of polymers and oligomers), but in order for the printing plates to have a realistic run length, it is highly desirable that the oleophilic resin should be capable of undergoing crosslinking subsequent to transfer to the receptor. A wide variety of materials have been shown to behave in this manner, under the action of heat or UV radiation, as described, for example, in U.S. Patent No. 5,395,729 and any of those materials may be suitable for use in the present invention.

A particularly preferred crosslinking resin system comprises a resin having a plurality of hydroxyl groups in reactive association with a latent curing agent of formula: 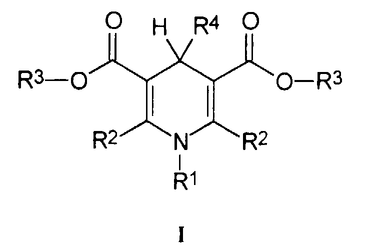 wherein R¹ represents H, an alkyl group, a cycloalkyl group or an aryl group; each R² independently represents an alkyl group or an aryl group; each R³ independently represents an alkyl group or an aryl group; and R⁴ represents an aryl group. R¹ preferably is any group compatible with formation of a stable pyridinium cation, which includes essentially any alkyl. cycloalkyl or aryl group. but for reasons of cost and convenience, simple alkyl groups (such as methyl, ethyl, and propyl) or simple aryl groups (such as phenyl and tolyl) are preferred.

Similarly, R² may represent essentially any alkyl or aryl group, but lower alkyl groups (such as methyl and ethyl) are preferred for reasons of cost and ease of synthesis.

R³ may also represent any alkyl or aryl group, but is preferably selected so that the corresponding alcohol or phenol, R³ - OH, is a good leaving group, as this promotes the transesterification reaction believed to be central to the curing mechanism. Thus, aryl groups comprising one or more electron-attracting substituents such as nitro, cyano, or fluorinated substituents, or alkyl groups of up to 10 carbon atoms are preferred. Most preferably, each R³ represents an alkyl group such as methyl, ethyl, and propyl, such that R³ - OH is volatile at temperatures of about 100"C and above.

R⁴ may represent any aryl group such as phenyl and naphthyl, including substituted derivatives thereof, but is most conveniently phenyl.

Analogous compounds in which R⁴ represents H or an alkyl group are not suitable for use in the invention, because such compounds react at ambient or moderately elevated temperatures with many of the infrared dyes suitable for use in the invention and hence the relevant compositions have a limited shelf life.

Preferred compounds of formula (I) suitable for use in the invention include the following:

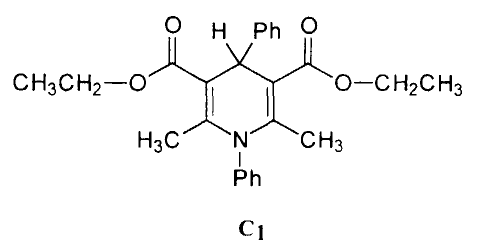

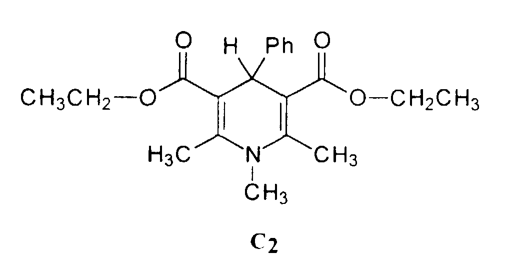

The relevant compounds may be prepared by known methods, e.g. by an adaptation of the Hantsch pyridine synthesis.

The resin having a plurality of hydroxy groups, may be selected from a wide variety of materials. Prior to laser address, the media ideally should be in the form of a smooth, tack-free coating, with sufficient cohesive strength and durability to resist damage by abrasion, peeling, flaking, and dusting in the course of normal handling and storage. If the hydroxy-functional resin is the sole or major resin component (which is the preferred situation), then its physical and chemical properties should be compatible with the above requirements. Thus, film-forming polymers with glass transition temperatures higher than ambient temperature are preferred. Preferably, the polymers are capable of dissolving or dispersing the other components of the transfer media, and themselves are soluble in the typical coating solvents such as lower alcohols, ketones, ethers, hydrocarbons, and haloalkanes. Since the transfer media are intended for printing plate applications, the resin preferably has oleophilic rather than hydrophilic properties.

The hydroxy groups may be alcohol groups or phenol groups (or both), but alcohol groups are preferred. The requisite hydroxy groups may be incorporated in a polymeric resin by polymerisation or copolymerisation of hydroxy-functional monomers such as allyl alcohol and hydroxyalkyl acrylates or methacrylates, or by chemical conversion of preformed polymers, e.g. by hydrolysis of polymers and copolymers of vinyl esters such as vinyl acetate. Polymers with a high degree of hydroxyl functionality, such as poly(vinyl alcohol) and cellulose are in principle suitable for use in the invention, but in practice their solubility and other physico-chemical properties are less than ideal for most applications. Derivatives of such polymers, obtained by esterification, etherification or acetalisation of the bulk of the hydroxy groups, generally exhibit superior solubility and film-forming properties, and provided that at least a minor proportion of the hydroxy groups remain unreacted, they are suitable for use in the invention. A preferred hydroxy-functional resin for use in the invention belongs to this class and is the product formed by reacting poly(vinyl alcohol) with butyraldehyde. Commercial grades of this material (supplied by Monsanto under the tradename BUTVAR) typically leave at least 5% of the hydroxyl groups unreacted and combine solubility in common organic solvents with excellent film-forming and pigment-dispersing properties.

Alternatively, a blend of "inert" and hydroxy-functional resins may be used, in which the inert resin provides the requisite film-forming properties which may enable the use of lower molecular weight polyols, but this is not preferred.

Another component of the transfer media is a colorant in the form of one or more dyes or pigments. Essentially any dye or pigment or mixture of dyes and/or pigments of the desired hue may be used as a colorant in the transfer media, but pigments in the form of dispersions of solid particles are particularly preferred. Solid-particle pigments typically have a much greater resistance to bleaching or fading on prolonged exposure to sunlight, heat, and humidity in comparison to soluble dyes, and hence can be used to form durable images, suitable for use outdoors or in other demanding environments. The use of pigment dispersions in color proofing materials is well known in the art. and any of the pigments previously used for that purpose may be used in the present invention. Pigments or blends of pigments matching the yellow, magenta, cyan and black references provided by the International Prepress Proofing Association (known as the SWOP color references) are particularly preferred, although the invention is not limited to those colors. Pigments of essentially any color may be used, including so-called "exotic" colors and those conferring special effects, such as, opalescence or fluorescence.

In preferred embodiments of the invention, the transfer media comprise a fluorochemical additive in addition to a dispersion of pigment particles, as disclosed in European Publication No. 0602893. The use of such an additive in an amount corresponding to at least one part by weight per 20 parts by weight of pigment, preferably at least one part per 10 parts by weight of pigment, provides much improved resolution and sensitivity in the laser thermal transfer process. Preferred fluorochemical additives comprise a perfluoroalkyl chain of at least six carbon atoms attached to a polar group, such as, carboxylic acid, ester, and sulphonamide.

Another component of the transfer media is an infrared absorber. While in principle any infrared absorbing dye or pigment may be used, provided it is capable of absorbing the output of the laser source and generating heat as a result; in practice it is perferred for accurate color proofing purposes that the IR absorber not contaminate the transferred image. This may be achieved by minimizing the extent to which the IR absorber co-transfers with the resin and colorant (e.g. by coating it in an underlayer to the layer comprising the resin and colorant), by selecting a dye with minimal visible coloration, or by providing means for bleaching the contaminating absorption during or subsequent to the transfer process, or by a combination of these techniques. In practice, it is difficult to completely eliminate co-transfer of the IR absorber, or to find dyes with no visible coloration, and so bleachable IR dyes are preferred. For example, EP 0675003 describes the bleaching of photothermal converting dyes in a laser thermal transfer imaging system. For use with the preferred crosslinkable binder system, the infrared absorber is preferably a cationic dye in which the infrared-absorbing chromophore bears a delocalized positive charge, which is balanced by a negatively-charged counterion, such as, perchlorate, tetrafluoroborate, and hexafluorophosphate. It is believed that dyes of this type can facilitate the oxidation of compounds of formula (I) to the corresponding pyridinium salts when photo-excited by laser irradiation. Suitable cationic infrared dyes include the class of amine cation radical dyes (also known as immonium dyes) disclosed, for example, in WO90/12342, JP51-088016 and (in greater detail) in European Patent EP-A-0739748. Included in this class are the diamine dication radical dyes (in which the chromophore bears a double positive charge), exemplified by materials, such as. Cyasorb™ IR165, which is commercially available from Glendale Protective Technologies Inc. Dyes of this class typically absorb over a broad range of wavelengths in the near infrared, making them suitable for address by YAG lasers as well as diode lasers.

Preferred infrared dyes for use in the invention belong to the class of cationic dyes known as the tetra-arylpolymethine (TAPM) dyes. Such dyes comprise a polymethine chain having an odd number of carbon atoms (5 or more), each terminal carbon atom of the chain being linked to two aryl substituents. The preferred dyes of this class have a nucleus of formula (II): 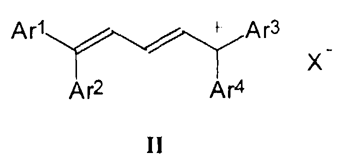 where Ar¹ - Ar⁴ are aryl groups which may be the same or different such that at least one of the aryl groups represented by Ar¹ - Ar⁴ bears a tertiary amino substituent (preferably in the 4-position), and X is an anion. Preferably no more than two of the aryl groups bear a tertiary amino substituent, and the aryl groups bearing the tertiary amino substituents are preferably attached to different ends of the polymethine chain. Examples of tertiary amino groups include dialkylamino groups (such as dimethylamino and diethylamino). diarylamino groups (such as diphenylamino), alkylarylamino groups (such as N-methylanilino), and heterocyclic groups such as pyrrolidino, morpholino or piperidino. The tertiary amino group may form part of a fused ring system, e.g. one or more of Ar¹ - Ar⁴ may represent a julolidine group.

The aryl groups represented by Ar¹ - Ar⁴ may comprise phenyl, naphthyl, or other fused ring systems, but phenyl rings are preferred. In addition to the tertiary amino groups discussed previously, substituents which may be present on the rings include alkyl groups (preferably of up to 10 carbon atoms), halogen atoms (such as Cl and Br), hydroxy groups, thioether groups and alkoxy groups. Substituents which donate electron density to the conjugated system, such as alkoxy groups, are particularly preferred.

Substituents, especially alkyl groups of up to 10 carbon atoms or aryl groups of up to 10 ring atoms, may also be present on the polymethine chain.

Preferably the anion X is derived from a strong acid (e.g. HX should have a pKa of less than 3, preferably less than 1). Suitable identities for X include ClO₄, BF₄, CF₃SO₃, PF₆, AsF₆, SbF₆ and perfluoroethylcyclohexylsulphonate.

Preferred dyes of this class include:

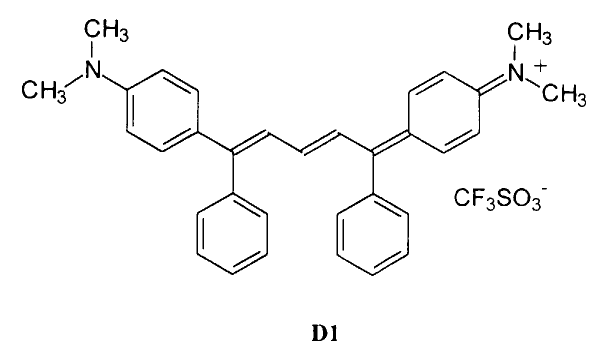

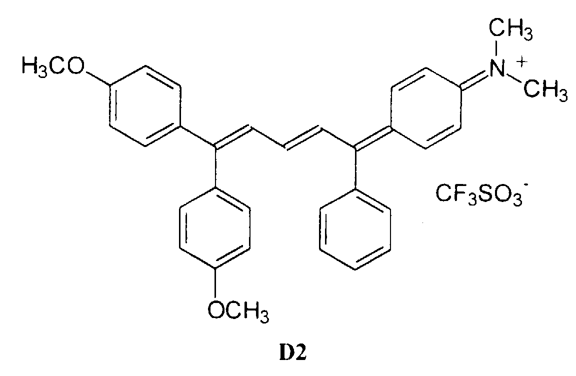

The relevant dyes may be synthesised by known methods, e.g. by conversion of the appropriate benzophenones to the corresponding 1,1-diarylethylenes (by the Wittig reaction, for example), followed by reaction with a trialkyl orthoester in the presence of strong acid HX.

The dyes of formula (II) generally absorb in the 700 to 900 nm region. making them suitable for diode laser address: see e.g., JP63-319191; JP63-319192; U.S. 4,950,639; EP 0602893; and EP 0675003 which disclose their use as absorbers in laser addressed thermal transfer media of different types.

Minor amounts of other ingredients may optionally be present in the transfer media, such as surfactants, coating aids, and pigment dispersing aids in accordance with known techniques.

The transfer media are formed as a coating on a support. The support may be any sheet-form material of suitable thermal and dimensional stability, and for most applications should be transparent to the exposing laser radiation. Polyester film base, of about 20 to 200 µm thickness, is particularly useful, and if necessary may be surface-treated so as to modify its wettability and adhesion to subsequently-applied coatings. Such surface treatments include corona discharge treatment and the application of subbing layers or release layers, including dynamic release layers such as those disclosed in U.S. Patent No. 5,171,650.

The transfer medium may be coated as a single layer, or as two or more contiguous layers. For example, the infrared dye may be coated as an underlayer with the remaining ingredients coated on top. Preferably the transfer medium comprising all the necessary components is coated in a single layer.

The relative proportions of the components of the transfer medium may vary widely, depending on the particular choice of ingredients. Generally, the infrared dye is present in sufficient quantity to provide a transmission optical density of at least 0.5, preferably at least 1.0, at the exposing wavelength, and the colorant provides a reflection optical density of at least 0.5, preferably at least 1.0, at the relevant viewing wavelength(s).

Preferred pigmented transfer media have the following approximate composition (all percentages are by weight):

| | |
|---|---|
| hydroxy-functional film-forming resin (e.g. Butvar™ B76) | 25 to 75% |
| | |
| latent curing agent (e.g. C1 or C2) | 10 to 40% |
| | |
| infrared dye (e.g. D1 or D2) | 5 to 25% |
| | |
| pigment | 10 to 40% |
| | |
| fluorochemical additive (e.g. a perfluoroalkylsulphonamide) | 1.5 to 15% |

Thin coatings (e.g. less than about 3 µm dry thickness) of the above formulation may be transferred to a variety of receptor sheets by laser irradiation. Transfer occurs with high sensitivity and resolution, and heating the transferred image for relatively short periods (e.g. one minute or more) at temperatures in excess of about 120°C causes curing and hardening, and hence an image of enhanced durability.

The transfer media are readily prepared by dissolving or dispersing the various components in a suitable organic solvent and coating the mixture on film base. Pigmented transfer media are most conveniently prepared by predispersing the pigment in the hydroxy-functional resin in roughly equal proportions by weight, in accordance with standard procedures used in the color proofing industry, thereby providing pigment "chips". Dispersing the chips in a solvent provides a millbase, to which further resin and solvents are added as required to give the final coating formulation. Any of the standard coating methods may be employed, such as roller coating, knife coating, gravure coating, and bar coating followed by drying at moderately elevated temperatures.

A wide variety of receptor sheets may he used in the practice of the invention. For the formation of printing plates, the receptor may be any of the commonly-used printing plate supports, and is typically an aluminium foil that has been subjected to one or more of the conventional treatments (i.e., graining, anodising, and etching) to provide a durable, hydrophilic surface. For color proofing purposes, the receptor is preferably paper (plain or coated) or a plastic film coated with a thermoplastic receiving layer, and may be transparent or opaque. Non-transparent receptor sheets may be diffusely-reflecting or specularly-reflecting. When the receptor sheet comprises a paper or plastic sheet coated with a thermoplastic receiving layer, the receiving layer is typically several micrometers thick, and may comprise any thermoplastic resin capable of providing a tack-free surface at ambient temperatures, and which is compatible with the transferred colorant. Preferably, the receiving layer comprises the same resin(s) as used as the binder(s) of the colorant transfer layer. When a receiving layer is present, it may advantageously contain a bleaching agent for the infrared dye, as disclosed in EP 0675003. Other useful bleaching agents include guanidine derivatives and dihydropyridines (described earlier as latent crosslinking agents).

The receptor sheet used for color proofing may be textured or otherwise engineered so as to present a surface having a controlled degree of roughness, e.g. by incorporating materials such as polymeric beads and silica particles in the receiving layer (see e.g., US 4,876,235). Alternatively, roughening agents may be incorporated in the transfer medium, as disclosed in EP 0163297, EP 0679531 and EP 0679532. When one (or both) of the donor and receptor sheets presents a roughened surface, vacuum draw-down of the one to the other is facilitated. It is highly desirable that the receptor used in the formation of the color proof should exhibit a degree of surface roughness that is similar to that shown by the hydrophilic receptor used in the plate-forming process. This provides further improvements in the matching of proof to plates by ensuring that the conditions under which the respective transfer processes occur are, as far as possible, identical.

The procedure for imagewise transfer of colorant from donor to receptor is conventional. The two elements are assembled in intimate face-to-face contact, e.g. by vacuum hold down or alternatively by means of the cylindrical lens apparatus described in US 5,475,418 and scanned by a suitable laser. The assembly may be imaged by any of the commonly used lasers, depending on the absorber used, near infrared emitting lasers, such as, diode lasers and YAG lasers, is preferred. Any of the known scanning devices may be used, e.g. flat-bed scanners, external drum scanners or internal drum scanners. In these devices, the assembly to be imaged is secured to the drum or bed, e.g., by vacuum hold-down, and the laser beam is focused to a spot, e.g., of about 20 µm diameter, on the IR-absorbing layer of the donor-receptor assembly. This spot is scanned over the entire area to be imaged while the laser output is modulated in accordance with electronically stored image information. Two or more lasers may scan different areas of the donor receptor assembly simultaneously, and if necessary, the output of two or more lasers may be combined optically into a single spot of higher intensity. Laser address is normally from the donor side, but may be from the receptor side if the receptor is transparent to the laser radiation.

Although any form of laser-mediated mass transfer may be suitable for the practice of the invention, curing and hardening of the transferred image is most effective when each pixel of the image remains substantially intact and coherent during the transfer from the donor to the receptor. Thus melt-stick transfer, in which the pixels are transferred in a molten or semi-molten state, is preferable to ablation transfer, which involves an explosive decomposition and/or vaporization of the imaging medium, and hence results in fragmentation of the transferred pixels. Factors which favor the melt-stick mechanism include the use of less-powerful lasers (or shorter scan times for a given laser output) and the absence from the imaging medium of binders which are self-oxidising or otherwise thermally-degradable, such as those disclosed in WO 90/12342.

Where appropriate, after peeling the donor sheet from the receptor, the image residing on the receptor is cured by subjecting it to a suitable treatment, such as UV irradiation or heat treatment, e.g. at temperatures in excess of about 120°C. This may be carried out by a variety of means, such as storage in an oven, hot air treatment, contact with a heated platen or passage through a heated roller device. For the purposes of color proofing, curing the transferred image is not strictly necessary, but may be desirable in the interests of a more durable image. In such a situation, it is more convenient to delay the curing step until all the separate colorant transfer steps have been completed, then provide a single heat treatment for the composite image. However, if the individual transferred images are particularly soft or easily damaged in their uncured state, then it may be necessary to cure and harden each monochrome image prior to transfer of the next, but in preferred embodiments of the invention, this is not necessary.

In some situations, the receptor on which a multicolor image is initially assembled is not the final substrate on which the image is viewed. For example, U.S. 5,126,760 discloses thermal transfer of a multicolor image to a first receptor, with subsequent transfer of the composite image to a second receptor for viewing purposes, and a similar technique may be used in the present invention.

The invention will be further illustrated by the following Examples in which the abbreviations and tradenames are represented by the following:

Butvar™ B-76 polyvinylbutyral resin available from Monsanto, with free OH content of 7 - 13 mole%.

Latent curing agent C1 has the following chemical structure:

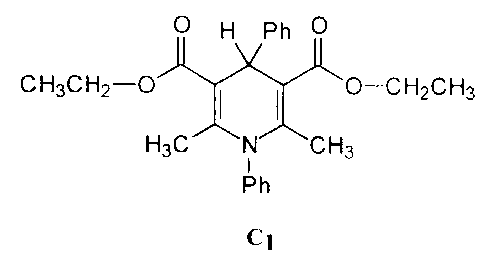

Infrared dye D1 has the following chemical structure:

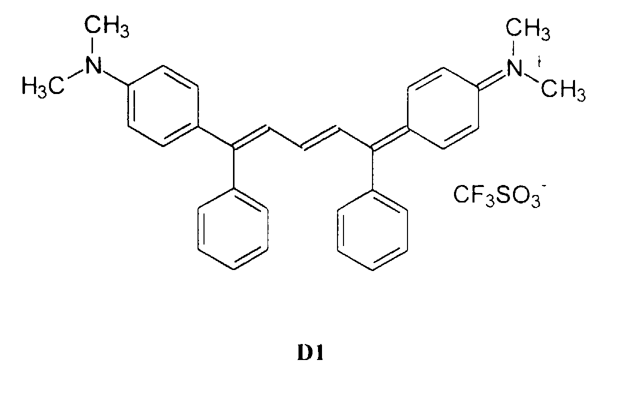

Disperbyk™ 161 is a dispersing agent available from BYK-Chemie.

MEK is methyl ethyl ketone (butan-2-one).

PET is a polyethyleneterephthalate film.

FC is N-methylperfluorooctylsulphonamide.

### Example 1

In the following formulations, all parts are by weight.

### Donor Sheets

Separate cyan, yellow, magenta and black millbases were prepared by milling the appropriate pigment (360 parts) with Butvar B-76 (240 parts) in the presence of Disperbyk 161 (101 parts) and 1-methoxypropan-2-ol (100 parts) on a two-roll mill. The "chips" produced were dispersed in a 1:1 mixture (by weight) of MEK and 1-methoxypropan-2-ol to provide millbases comprising 15 % solids (by weight). Coating formulations were prepared by mixing millbase, Butvar B-76 resin solution, MEK, infrared dye, curing agent and ethanol (in that order) in the quantities shown below, stirring until the dye had dissolved, then adding the FC.

| | Cyan | Yellow | Magenta | Black |
|---|---|---|---|---|
| Millbase | 497 | 423 | 692 | 577* |
| | | | | |
| Butvar™ B-76 (15wt% in MEK) | 684 | 278 | 377 | 492 |
| | | | | |
| Infrared dye D1 | 30 | 30 | 20 | 15 |
| | | | | |
| Curing agent C1 | 38.5 | 38.5 | 34 | 34 |
| | | | | |
| MEK | 1335 | 1020 | 1158 | 1155 |
| | | | | |
| Ethanol | 268 | 193 | 220 | 220 |
| | | | | |
| FC | 10 | 7.7 | 9 | 9 |

| | | | | |
|---|---|---|---|---|
| * 473 parts black mixed with 29 parts magenta + 75 parts cyan millbases. | | | | |

Colorant donor sheets were prepared by bar coating the separate formulations on 50 µm PET base to provide a thickness of about 1 µm after drying at 93°C.

### Color Proof

A paper receptor sheet (bearing a colorless coating of Butvar™ B-76 resin) was mounted on an external drum laser scanning device, and a sample of the cyan donor was secured in face-to-face contact with it, using adhesive tape. The assembly was exposed to laser diode radiation (580 mW at 870nm, focused to a 30 µm spot) at a scan rate of 200 cm/sec, the laser output being modulated in accordance with cyan negative color separation data. After this exposure was complete, the cyan donor was removed and replaced by the magenta donor, and the imaging process repeated, with modulation in accordance with magenta negative color separation data. Thereafter, yellow and black separation images were transferred to the same receptor in register by the identical technique. The composite image was finally exposed to UV radiation (sunlight) to bleach residual staining from the infrared dye. The result was a full color image of high quality, with the full tonal range of 1 - 99 % dots (150 line screen) reproduced accurately.

### Printing Plates

An unexposed Viking™ plate (commercially available from Imation Corp.) was washed in its normal developer solution to remove the photosensitive coating, dried, then mounted on the drum of the same scanning laser exposure device as used above. A further sample of the cyan donor sheet described above was taped in face-to-face contact with the aluminium receptor and the assembly exposed under the same conditions as before, using the same cyan color separation data. The process was repeated using the magenta, yellow and black donors and a fresh plate support in each case. The result was a set of plates bearing the appropriate separation images which were an excellent match of the corresponding images on the proof.

To assess the potential run length of the plates, one of them (the magenta) was baked at 160°C for 3 minutes, then tested on a Praktika™ 00 press using Vanson™ 40904 ink, Imation Viking™ fountain solution and Royal Print™ 700 Glosscoat paper. It rolled up cleanly and easily, and showed no signs of wear after 3000 impressions, when the test was terminated.

## Claims

1. A method of image reproduction comprising the steps of:
(a) generating separate digital data sets representative of color separation images for a multicolor image;
(b) providing a first laser thermal transfer donor element comprising a support having coated thereon one or more layers comprising an infrared absorber and a dispersion of a colorant in an oleophilic resin, said colorant matching the color of one of said color separation images;
(c) assembling said first donor element in contact with a first receptor;
(d) scanning said first donor element with a laser having an output modulated in accordance with the digital data set representative of the separation image whose color matches the colorant used in step (b);
(e) transferring said one or more layers of said first donor element in areas struck by said laser to form an image on said first receptor;
(f) providing a second laser thermal transfer donor element identical to said first laser thermal transfer donor;
(g) assembling said second donor element in contact with a second receptor having a hydrophilic surface suitable for use in lithographic printing;
(h) scanning said second donor element with said laser modulated in accordance with the same digital data set as used in step (d);
(i) transferring said one or more layers in areas struck by said laser to form an image on said second receptor; and
(j) repeating steps (b) through (i) at least once, wherein a different colorant is used on each repetition of step (b), the first receptor is used on each repetition of step (c), and a different hydrophilic receptor is used on each repetition of step (g).

2. The method of Claim 1 wherein all the repetitions of steps (b) and (e) are conducted before any of steps (f) and (i) are conducted.

3. The method of Claim 1 or Claim 2 wherein said oleophilic resin comprises a plurality of hydroxyl groups.

4. The method of Claim 3 wherein said oleophilic resin is a reaction product of poly(vinyl alcohol) with butyraldehyde.

5. The method of Claim 3 or Claim 4 wherein said first and second transfer elements comprise a latent curing agent having the following formula: 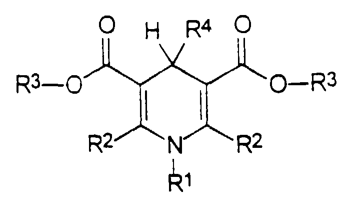 wherein
R¹ is selected from the group consisting of a H, an alkyl group, a cycloalkyl group and an aryl group;
each R² independently is an alkyl group or an aryl group;
each R³ independently is an alkyl group or an aryl group; and
R⁴ is an aryl group.

6. The method of Claim 5 wherein R¹, R² and R³ independently are an alkyl group of 1 to 5 carbon atoms and R⁴ is an optionally substituted phenyl group.

7. The method of Claim 5 wherein said curing agent is selected from the group consisting of 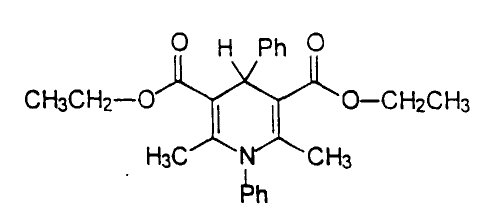 and

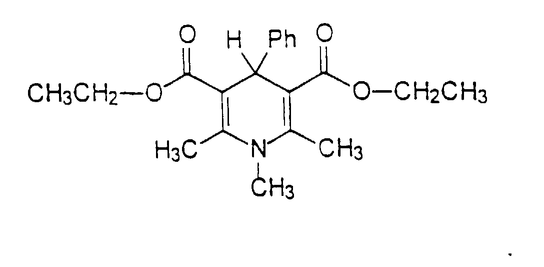

8. The method of any preceding Claim wherein said infrared absorber has a nucleus having the formula: 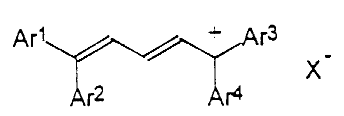 wherein:
Ar¹, Ar², Ar³ and Ar⁴ are aryl groups which may be the same or different such that at least one of said aryl groups bears at least one tertiary amino substituent and
X⁻ is an anion.

9. The method of Claim 8 wherein Ar¹ or Ar² and Ar³ or Ar⁴ bear at least one tertiary amino substituent.

10. The method of Claim 8 wherein said infrared absorber is selected from the group consisting of 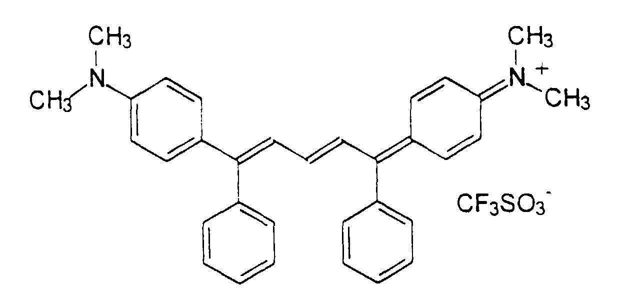 and

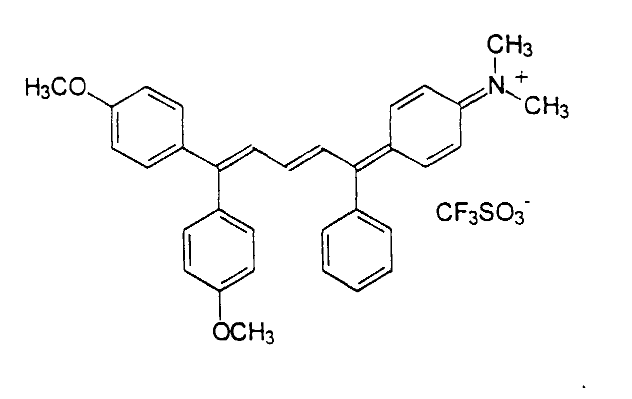

11. The method of any preceding Claim wherein said first and second transfer elements additionally comprise a fluorochemical additive comprising a perfluoroalkyl chain of at least 6 carbon atoms attached to a polar group.

12. The method of any one of Claims 3 to 11 wherein said first and second transfer element comprise a transfer medium having the following ranges of components:
| | |
|---|---|
| hydroxy-functional film-forming resin | 25 to 75% |
| latent curing agent | 10 to 40% |
| infrared dye | 5 to 25% |
| pigment | 10 to 40% |
| fluorochemical additive | 1.5 to 15% |

13. The method of any preceding Claim wherein said first receptor comprises plain paper, coated paper, or plastic film coated with a thermoplastic receiving layer.

14. The method of any preceding Claim wherein said second receptor comprises a printing plate support.

15. The method of Claim 14 wherein said second receptor comprises aluminium foil which has been treated by graining, anodising or etching to provide a durable hydrophilic surface.

16. The method of any preceding Claim wherein the image residing on said first or second receptor is cured by UV irradiation or heat treatment.

17. The method of any preceding Claim further comprising the step of using said second receptor after step (i) as a lithographic printing plate.

## Patentansprüche

1. Verfahren zur Vervielfältigung von Bildern, umfassend die Schritte:
(a) Erzeugung separater digitaler Datensätze für die Farbauszugsbilder eines mehrfarbigen Bildes;
(b) Bereitstellen eines ersten Thermolaserdonorelements, umfassend einen Träger, auf dem eine oder mehrere Schichten aufgetragen sind, die einen Infrarotabsorber und eine Dispersion eines Farbstoffes in einem lipophilen Harz enthalten, wobei der Farbstoff mit einer der Farben der Farbauszugsbilder übereinstimmt;
(c) Anordnen des ersten Donorelements in Kontakt mit einem ersten Rezeptor;
(d) Scannen des ersten Donorelements durch einen Laser, dessen Leistung in Übereinstimmung mit dem digitalen Datensatz des Farbauszugsbildes, dessen Farbe mit dem Farbstoff aus Schritt (b) übereinstimmt, moduliert wird;
(e) Übertragen einer oder mehrerer Schichten des ersten Donorelements in durch den Laser erfassten Gebieten, wodurch ein Bild auf dem ersten Rezeptor erzeugt wird;
(f) Bereitstellen eines mit dem ersten Thermolaserdonors identischen zweiten Thermolaserdonorelements;
(g) Anordnen des zweiten Donorelements in Kontakt mit einem zweiten Rezeptor, der eine für lithoghraphischen Druck geeignete hydrophile Oberfläche aufweist;
(h) Scannen des zweiten Donorelements mit dem in Übereinstimmung mit dem gleichen digitalen Datensatz wie in Schritt (d) modulierten Laser;
(i) Übertragen einer oder mehrerer Schichten in durch den Laser erfassten Gebieten zur Erzeugung eines Bildes auf diesem zweiten Rezeptor; und
(j) mindestens einmaliges Wiederholen der Schritte (b) bis (i), wobei ein unterschiedlicher Farbstoff bei jeder Wiederholung von Schritt (b) verwendet wird, der erste Rezeptor bei jeder Wiederholung von Schritt (c) verwendet wird, und ein unterschiedlicher hydrophiler Rezeptor bei jeder Wiederholung von Schritt (g) verwendet wird;

2. Verfahren gemäss Anspruch 1, wobei alle Wiederholungen der Schritte (b) und (e) durchgeführt werden, bevor einer der Schritte (f) und (i) durchgeführt wird.

3. Verfahren gemäss Anspruch 1 oder 2, wobei das lipophile Harz eine Vielzahl von Hydroxylgruppen enthält.

4. Verfahren gemäss Anspruch 3, wobei das lipophile Harz ein Reaktionsprodukt von Polyvinylalkohol mit Butyraldehyd ist.

5. Verfahren gemäss Anspruch 3 oder 4, wobei die ersten und zweiten Transferelemente einen latenten Härter der folgenden Formel enthalten: 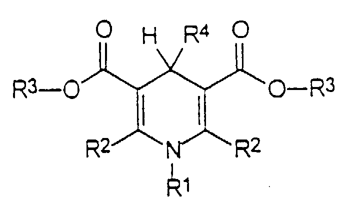 wobei
R¹ aus der durch H, einen Alkylrest, einen Cycloalkylrest und einen Arylrest gebildeten Gruppe ausgewählt ist;
jeder Rest 2 unabhängig voneinander ein Alkylrest oder ein Arylrest ist;
jeder Rest 3 unabhängig voneinander ein Alkylrest oder ein Arylrest ist;
und
R⁴ ein Arylrest ist.

6. Verfahren gemäss Anspruch 5, wobei R¹, R², und R³ unabhängig voneinander ein Alkylrest von 1 bis 5 Kohlenstoffatomen sind und R⁴ ein gegebenenfalls substituierter Phenylrest ist.

7. Verfahren gemäss Anspruch 5, wobei der latente Härter aus der aus 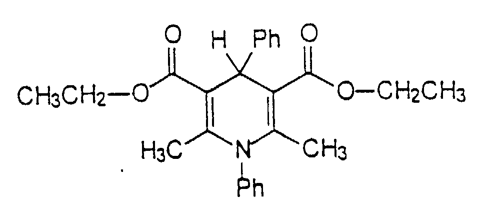 und 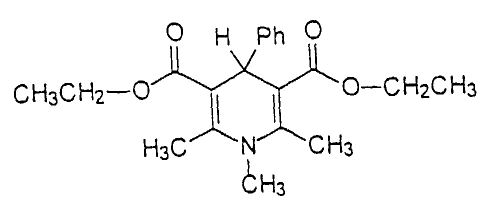 bestehenden Gruppe ausgewählt ist.

8. Verfahren gemäss einem der vorangehenden Ansprüche, wobei der Infrarotabsorber ein Grundgerüst folgender Formel hat: 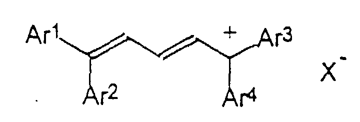 wobei:
Ar¹, Ar², Ar³ und Ar⁴ Arylreste sind, die gleich oder unterschiedlich sein können, derart dass mindestens einer der Arylreste mindestens einen tertiären Aminosubstituenten trägt und
X⁻ ein Anion ist.

9. Verfahren gemäss Anspruch 8, wobei Ar¹ oder Ar² und Ar³ oder Ar⁴ mindestens einen tertiären Aminosubstituenten tragen.

10. Verfahren gemäss Anspruch 8, wobei der Infrarotabsorber aus der aus 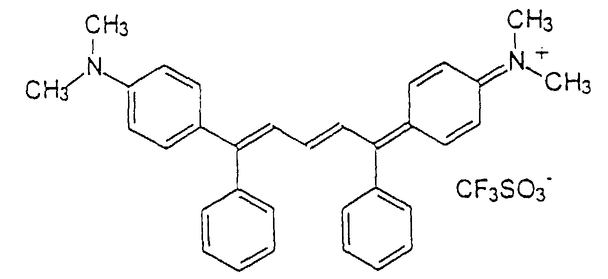 und 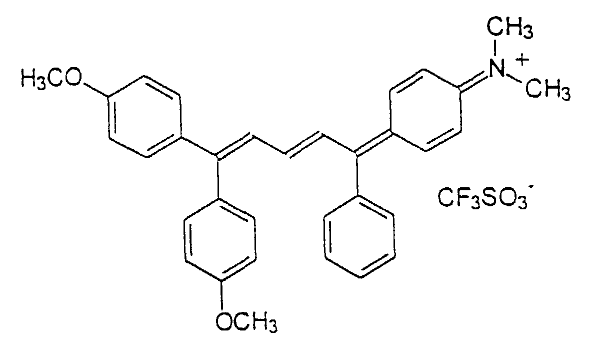 bestehenden Gruppe ausgewählt ist.

11. Verfahren gemäss einem der vorangehenden Ansprüche, wobei die ersten und die zweiten Transferelemente zusätzlich ein fluorochemisches Additiv, das eine an eine polare Gruppe gebundene perfluorierte Alkylkette mit mindestens 6 Kohlenstoffatomen enthält, umfassen.

12. Verfahren gemäss einem der Ansprüche 3 bis 11, wobei die ersten und die zweiten Transferelemente ein Transfermedium umfasst, dessen Komponenten innerhalb der folgenden Bereiche liegen:
| | |
|---|---|
| hydroxyfunktionales filmbildendes Harz | 25 bis 75 % |
| latenter Härter | 10 bis 40 % |
| Infrarotfarbstoff | 5 bis 25 % |
| Pigment | 10 bis 40 % |
| fluorochemisches Additiv | 1,5 bis 15 % |

13. Verfahren gemäss einem der vorangehenden Ansprüche, wobei der erste Rezeptor einfaches Papier, beschichtetes Papier, oder einen mit einer thermoplastischen Rezeptorschicht beschichteten Plastikfilm umfasst.

14. Verfahren gemäss einem der vorangehenden Ansprüche, wobei der zweite Rezeptor eine Druckplattenhalterung umfasst.

15. Verfahren gemäss Anspruch 14, wobei der zweite Rezeptor Aluminiumfolie, die durch Sandstrahlung, Anodisierung oder durch Ätzung zur Erzeugung einer dauerhaft hydrophilen Oberfläche behandelt wurde, umfasst.

16. Verfahren gemäss einem der vorangehenden Ansprüche, wobei das sich auf dem ersten oder dem zweiten Rezeptor befindende Bild durch UV-Strahlung oder durch Behandlung mit Hitze gehärtet wird.

17. Verfahren gemäss einem der vorangehenden Ansprüche, das weiterhin den Schritt der Verwendung des zweiten Rezeptors nach Schritt (i) als lithographische Flachdruckplatte umfasst.

## Revendications

1. Procédé de reproduction d'image comprenant les étapes consistant à :
(a) générer des ensembles de données numériques séparés représentatifs d'images de séparation de couleurs pour une image multicolore ;
(b) disposer un premier élément donneur par transfert thermique à laser comprenant un support sur lequel sont déposées une ou plusieurs couches comprenant un agent absorbant les infrarouges et une dispersion d'un colorant dans une résine oléophile, ledit colorant correspondant à la couleur de l'une desdites images de séparation de couleurs ;
(c) assembler ledit premier élément donneur en contact avec un premier récepteur ;
(d) balayer ledit premier élément donneur avec un laser ayant une sortie modulée conformément à l'ensemble de données numériques représentatif de l'image de séparation dont la couleur correspond au colorant utilisé dans l'étape (b) ;
(e) transférer ladite ou lesdites couches dudit premier élément donneur dans des zones frappées par ledit laser pour former une image sur ledit premier récepteur ;
(f) disposer un deuxième élément donneur par transfert thermique à laser identique audit premier donneur par transfert thermique à laser ;
(g) assembler ledit deuxième élément donneur en contact avec un deuxième récepteur ayant une surface hydrophile appropriée pour une utilisation en impression lithographique ;
(h) balayer ledit deuxième élément donneur avec ledit laser modulé conformément au même ensemble de données numériques que celui utilisé dans l'étape (d) ;
(i) transférer ladite ou lesdites couches dans des zones frappées par ledit laser pour former une image sur ledit deuxième récepteur ; et
(j) répéter les étapes (b) à (i) au moins une fois, où un colorant différent est utilisé pour chaque répétition de l'étape (b), le premier récepteur est utilisé pour chaque répétition de l'étape (c), et un récepteur hydrophile différent est utilisé pour chaque répétition de l'étape (g).

2. Procédé selon la revendication 1, dans lequel toutes les répétitions des étapes (b) et (e) sont réalisées avant que l'une quelconque des étapes (f) et (i) soit réalisée.

3. Procédé selon la revendication 1 ou la revendication 2, dans lequel ladite résine oléophile comprend une pluralité de groupes hydroxyle.

4. Procédé selon la revendication 3, dans lequel ladite résine oléophile est le produit de la réaction de poly(alcool vinylique) avec du butyraldéhyde.

5. Procédé selon la revendication 3 ou la revendication 4, dans lequel lesdits premier et deuxième éléments de transfert comprennent un agent de durcissement latent de formule suivante : 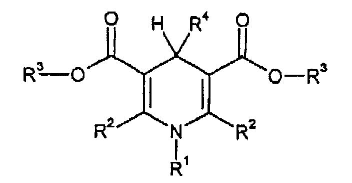 dans laquelle
R¹ est choisi dans l'ensemble constitué par H, un groupe alkyle, un groupe cycloalkyle et un groupe aryle ;
chaque R² est indépendamment un groupe alkyle ou un groupe aryle ;
chaque R³ est indépendamment un groupe alkyle ou un groupe aryle ; et
R⁴ est un groupe aryle.

6. Procédé selon la revendication 5, dans lequel R¹, R² et R³ sont indépendamment un groupe alkyle ayant de 1 à 5 atomes de carbone et R⁴ est un groupe phényle éventuellement substitué.

7. Procédé selon la revendication 5, dans lequel ledit agent de durcissement est choisi dans l'ensemble constitué par 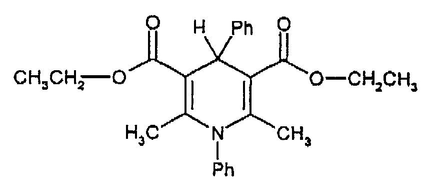 et

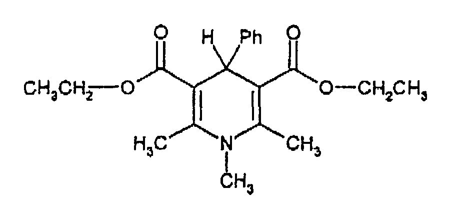

8. Procédé selon l'une quelconque des revendications précédentes, dans lequel ledit agent absorbant les infrarouges a un noyau de formule : 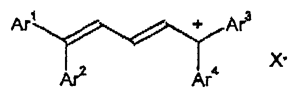 dans laquelle
Ar¹, Ar², Ar³ et Ar⁴ sont des groupes aryle qui peuvent être identiques ou différents de telle sorte qu'au moins l'un desdits groupes aryle porte au moins un substituant amino tertiaire, et
X⁻ est un anion.

9. Procédé selon la revendication 8, dans lequel Ar¹ ou Ar² et Ar³ ou Ar⁴ portent au moins un substituant amino tertiaire.

10. Procédé selon la revendication 8, dans lequel ledit agent absorbant les infrarouges est choisi dans l'ensemble constitué par 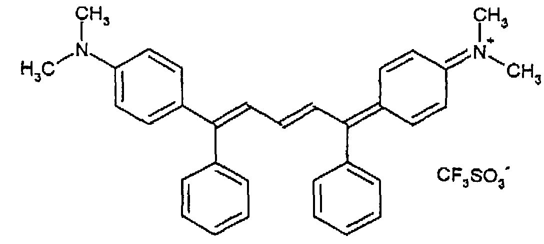 et

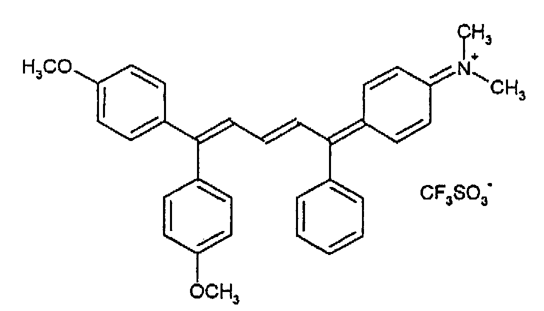

11. , Procédé selon l'une quelconque des revendications précédentes, dans lequel lesdits premier et deuxième éléments de transfert comprennent de plus un additif chimique fluoré comprenant une chaîne perfluoroalkyle ayant au moins 6 atomes de carbone, rattachée à un groupe polaire.

12. Procédé selon l'une quelconque des revendications 3 à 11, dans lequel lesdits premier et deuxième éléments de transfert comprennent un milieu de transfert ayant les plages suivantes de composants :
| | |
|---|---|
| résine filmogène à fonctionnalité hydroxy | 25 à 75 % |
| agent de durcissement latent | 10 à 40 % |
| colorant infrarouge | 5 à 25 % |
| pigment | 10 à 40 % |
| additif chimique fluoré | 1,5 à 15 % |

13. Procédé selon l'une quelconque des revendications précédentes, dans lequel ledit premier récepteur comprend du papier brut, du papier couché, ou un film plastique revêtu d'une couche réceptrice thermoplastique.

14. Procédé selon l'une quelconque des revendications précédentes, dans lequel ledit deuxième récepteur comprend un support de plaque d'impression.

15. Procédé selon la revendication 14, dans lequel ledit deuxième récepteur comprend une feuille d'aluminium qui a été traitée par grainage, anodisation ou gravure pour conférer une surface hydrophile durable.

16. Procédé selon l'une quelconque des revendications précédentes, dans lequel l'image résidant sur ledit premier ou deuxième récepteur est durcie par irradiation UV ou traitement thermique.

17. Procédé selon l'une quelconque des revendications précédentes, comprenant en outre l'étape d'utilisation dudit deuxième récepteur après l'étape (i) à titre de plaque d'impression lithographique.
